# EUROPEAN PATENT SPECIFICATION

(11) **EP 0 387 935 B1**
(45) Date of publication and mention of the grant of the patent: **30.11.1994**
(21) Application number: 90200509.9
(22) Date of filing: 05.03.1990
(51) Int. Cl.: G11C 16/02

(54) **Table cloth matrix of EPROM memory cells with an asymmetrical fin**
Tischtuchmatrix von EPROM-Speicherzellen mit einer asymmetrischen Leitplatte
Matrice de drap de cellules à mémoire EPROM avec une tôle-guide asymétrique

(30) Priority: 15.03.1989 IT 1977889
(43) Date of publication of application: 19.09.1990
(73) Proprietor: SGS-THOMSON MICROELECTRONICS s.r.l., 20041 Agrate Brianza (Milano) (IT)
(72) Inventor: Mazzali, Stefano, I-20135 Milano (IT)
(74) Representative: Mittler, Enrico

(56) References cited:
- US-A- 4 258 466

## Description

The present invention relates to a table cloth matrix of EPROM memory cells with an asymmetrical fin.

In the field of memories with EPROM cells one of the fundamental problems is the density of the cells; it is important to succeed in compacting the memory cells as much as possible the better to exploit the available space and to improve performance. For this reason research is oriented towards the study of new structures which overcome these problems.

One of these new structures is the so-called "table cloth" matrix, wherein two groups of source lines and one group of drain lines parallel and alternated to one another are intersected perpendicularly by control gate lines parallel to one another, while floating gate areas are interposed between said source and drain lines beneath said control gate lines.

This configuration is described in US-A-4792925 and allows the attainment of good levels of miniaturization and of cell density.

One of the main defects of this structure is the low capacitive coupling between the control gate and the floating gate of each cell.

In fact the coupling area between the gates is practically identical to that between the floating gate and the substrate so that the capacitive ratio is lower than that of standard EPROM cells, and the cell's writing characteristics are thus worsened. The memory is thus highly sensitive to the so-called "drain turn-on", a parasitic effect which can lead to soft-erasing effects in non-selected cells.

An improvement on this structure is illustrated in EP-A-0352830. In this structure islands of field oxide are provided in the matrix zone, which, while allowing an improvement in the capacitive coupling between the gates, involve a greater complexity of manufacture and a lower degree of obtainable integration.

In EP-A-0372614 a variant of the table cloth matrix structure is described. In this Application there are provided field oxide areas formed by the control gate lines, and the floating and control gates are provided with symmetrical lateral fins which are superimposed over the field oxide areas. In this structure the control gate is effectively coupled to the underlying layer only at narrow lateral fins, while in the central zone coupling is reduced by an oxide layer residue from a planarization stage included in the manufacturing process of the matrix. Thus the coupling area between the gates is extremely small, and this worsens coupling, if it does not altogether prevent it.

US-A-4258466 discloses a structure according to the preamble of claim 1.

The object of the present invention is to accomplish a matrix of EPROM memory cells of the table cloth type which offers an improved capacitive ratio without requiring particular manufacturing techniques, and which allows considerable compacting possibilities.

According to the invention such object is attained with a matrix of EPROM memory cells as defined in claim 1.

In this way each control gate is effectively coupled to the underlying floating gate area at the extensive surface of the latter's lateral fin. This improves electrical coupling between the two gates, increasing the capacitive ratio and thus the performance of the cell.

The part of the control gate which is superimposed, with interposed planarization oxide, on the part of the floating gate close to the substrate is much reduced, and thus its effect is negligible.

The characteristics and the advantages of the present invention shall be made more evident by the following detailed description of some possible embodiments illustrated as non-limiting examples in the following drawings wherein:
Fig. 1 is a perspective cross-section of a portion of a checkerboard matrix according to the invention;

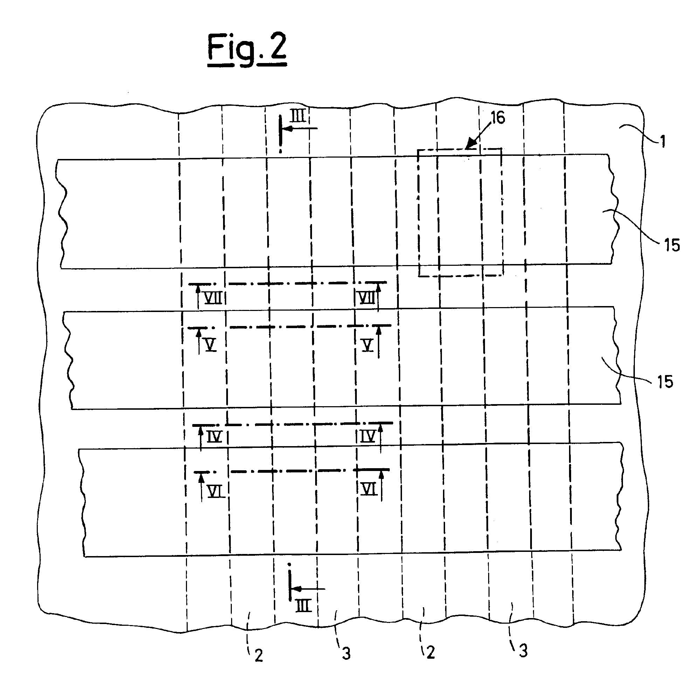

Fig. 2 is a plan view from above of a portion of the checkerboard matrix of Fig. 1;

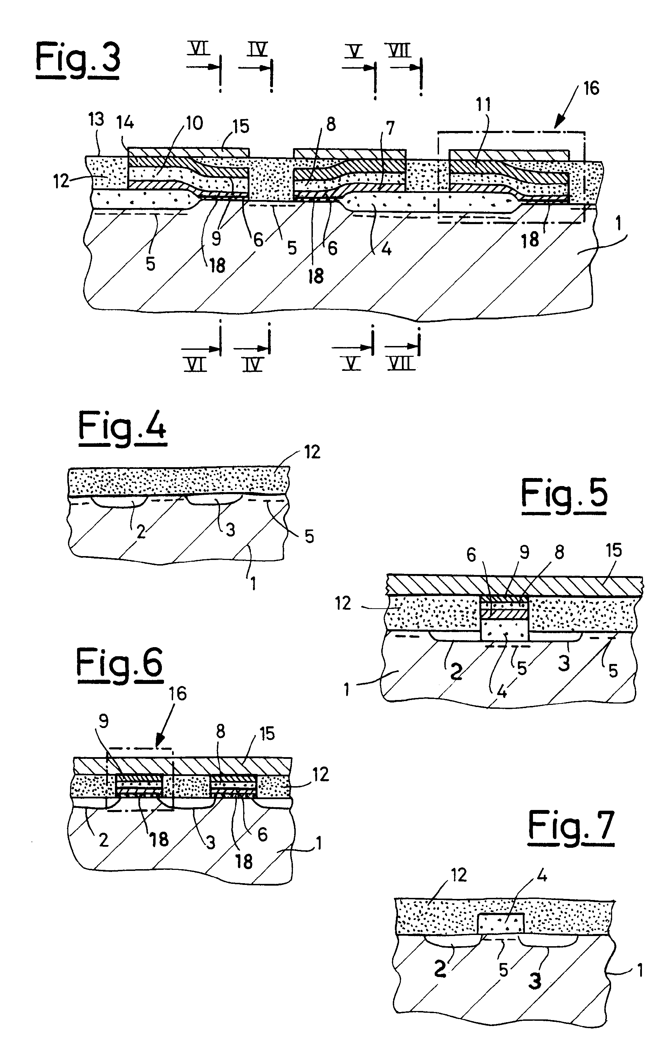

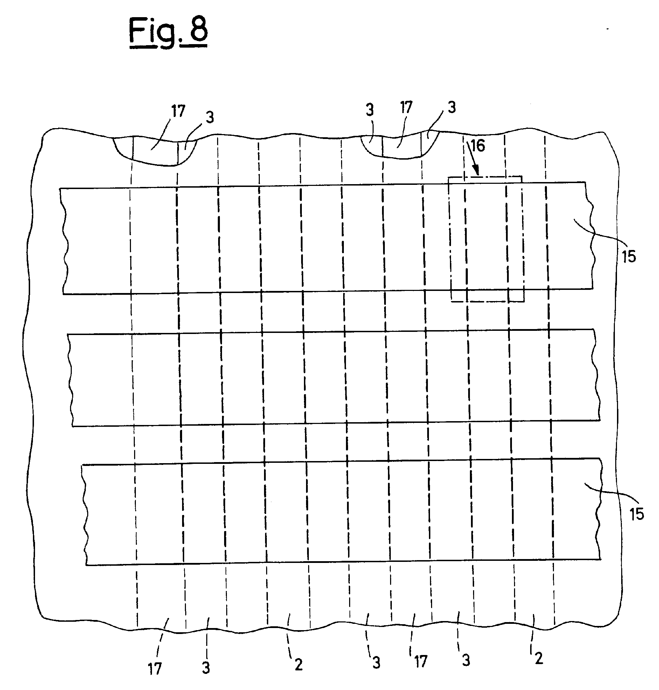

Fig. 3 shows said portion of the checkerboard matrix in a cross-sectional view taken along the line III-III of Fig. 2;
Fig.s 4, 5, 6 and 7 show enlarged details of the above table cloth matrix, along the lines IV-IV, V-V, VI-VI and VII-VII, respectively, of Fig.s 2 and 3;
Fig. 8 shows a plan view from above of a portion of a further embodiment of the checkerboard matrix according to the invention.

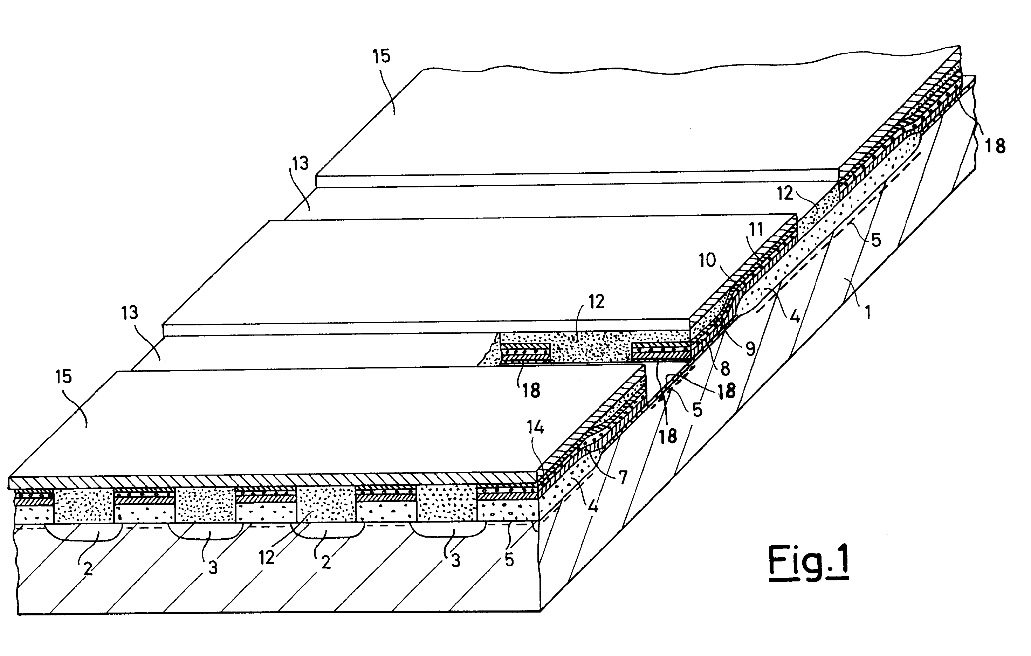

The memory matrix consists of a substrate 1 (Fig. 1) in which there are obtained parallel source lines 2 and drain lines 3 (Fig.s 1 and 2). An insulating system 5 is diffused in the substrate by means of a doping agent. As shall be made clearer later, this insulating system 5 is diffused only in the areas wherein there is an oxide in contact with said substrate 1 so as to avoid residual diffusion currents. Extensive areas of field oxide 4 are grown on substrate 1, interposed between the source lines 2 and the drain lines 3. Areas of floating gate 6 with underlying oxide layers 18 are arranged in a checkerboard pattern between said source lines 2 and drain lines 3. As shown in Fig.s 1 and 3, the areas of floating gate 6 have an asymmetrical fin 7 which is superimposed on the field oxide 4. Areas of dielectric 8 and areas of barrier polysilicon 9 are arranged on the areas of floating gate 7. Both the areas of dielectric 8 and the areas of polysilicon 9 have a fin, 10 and 11 respectively, which is superimposed and aligned over the corresponding fin 7 of the underlying floating gate 6.

Areas of planarized oxide 12 are deposited between each group formed by floating gate 6, areas of dielectric 8 and of polysilicon 9. These oxide areas constitute the residue of the thick planarization oxide after its removal until the upper surface 13 of the oxide itself coincides with the upper surface 14 of fin 11 of polysilicon 9.

Lastly control gate lines 15, say of polysilicon, are arranged perpendicularly to the source lines 2 and to the drain lines 3, in a condition superimposed and self-aligned with each group formed by floating gate 6, by dielectric area 8 and polysilicon area 9.

There is thus obtained in this way a matrix of EPROM memory cells, such as that indicated with 16 in Fig.s 2, 3 and 6.

As already mentioned, the insulation system 5 exists only in the areas of contact between field oxide 4 or planarized oxide 12 and substrate 1.

The checkerboard matrix according to the invention is also applicable to the memory matrix structure illustrated in EP-A-0352830, as shown in Fig. 8.

In this structure two drain lines 3 are alternated with each source line 2 and strips of oxide 17 are also present, parallel to the source lines and to the drain lines, which divide the matrix of memory cells into a plurality of groups of cells insulated from one another. In this way a checkerboard memory matrix is obtained, whose individual cells are accessible by traditional decoding.

## Claims

1. Matrix of EPROM memory cells, comprising a semiconductor substrate (1), source lines (2) and drain lines (3) parallel and alternated to one another on said substrate (1), floating gate areas (6) interposed in a table cloth pattern between said source lines (2) and drain lines (3), control gate lines (15) parallel to one another and perpendicular to said source lines (2) and drain lines (3) in a condition superimposed over an intermediate dielectric (8) and aligned with respect to said floating gate areas (6), and extensive areas of field oxide (4) formed on said substrate (1), wherein areas of dielectric (8) and areas of polysilicon (9) connected to the control gate lines (15) are superimposed over and self-aligned with said floating gate areas (6), said areas of dielectric (8) and polysilicon (9) being provided with respective fins (10, 11) superimposed over the corresponding fins (7) of the underlying floating gate areas (6), characterized in that each of said floating gate areas (6) is provided with a single lateral fin (7) and in that the single lateral fins (7) of pairs of adjacent floating gate areas (6) which are interposed between the same source (2) and drain (3) lines are superimposed with an extensive coupling surface over opposite ends of corresponding ones of said field oxide areas (4) so that substantially all of said field oxide areas (4) have corresponding pairs of floating gate areas (6).

2. Cell matrix (16) according to claim 1, characterized in that each source line (2) is alternated with a pair of drain lines (3) and that oxide strips (17) are interposed between said drain lines (3).

## Patentansprüche

1. Matrix aus EPROM-Speicherzellen, mit einem Halbleitersubstrat (1), mit Sourceleitungen (2) und Drainleitungen (3), die parallel zueinander und einander abwechselnd auf dem Substrat (1) angeordnet sind, mit Bereichen mit schwebendem Gate (6), die in einem Tischtuchmuster zwischen den Sourceleitungen (2) und den Drainleitungen (3) angeordnet sind, mit Steuergateleitungen (15), die parallel zueinander und senkrecht zu den Sourceleitungen (2) und den Drainleitungen (3) über einem zwischengeordneten Dielektrikum (8) angeordnet und in bezug auf die Bereiche mit schwebendem Gate (6) ausgerichtet sind, und mit ausgedehnten Feldoxidbereichen (4), die auf dem Substrat (1) ausgebildet sind, wobei Bereiche aus Dielektrikum (8) und Bereiche aus Polysilizium (9), die mit den Steuergateleitungen (15) verbunden sind, über den Bereichen mit schwebendem Gate (6) angeordnet und mit diesen selbstausgerichtet sind, wobei die Bereiche aus Dielektrikum (8) und Polysilizium (9) mit jeweiligen Flossen (10, 11) versehen sind, die über den entsprechenden Flossen (7) der darunterliegenden Bereiche mit schwebendem Gate (6) angeordnet sind,
dadurch gekennzeichnet, daß jeder der Bereiche mit schwebendem Gate (6) mit einer einzelnen seitlichen Flosse (7) versehen ist, und daß die einzelnen seitlichen Flossen (7) von Paaren einander benachbarter Bereiche mit schwebendem Gate (6), die zwischen denselben Source- (2) und Drainleitungen (3) angeordnet sind, von einer ausgedehnten Kopplungsfläche über einander gegenüberliegenden Enden entsprechender Feldoxidbereiche (4) überlagert sind, so daß im wesentlichen alle der Feldoxidbereiche (4) entsprechende Paare von Bereichen mit schwebendem Gate (6) aufweisen.

2. Zellenmatrix (16) nach Anspruch 1,
dadurch gekennzeichnet, daß jede Sourceleitung (2) abwechselnd mit einem Paar Drainleitungen (3) angeordnet ist, und daß Oxidstreifen (17) zwischen den Drainleitungen (3) angeordnet sind.

## Revendications

1. Matrice de cellules mémoire EPROM comprenant un substrat semiconducteur (1), des lignes de source (2) et des lignes de drain (3) parallèles et alternées sur le substrat (1), des zones de grille flottante (6) interposées selon un motif en damier entre les lignes de source (2) et les lignes de drain (3), des lignes de grille de commande (15) parallèles les unes aux autres et perpendiculaires aux lignes de source (2) et aux lignes de drain (3) selon un état de superposition sur un diélectrique intermédiaire (8) et alignées par rapport aux zones de grille flottante (6), et des zones importantes d'oxyde de champ (4) formées sur le substrat (1), dans laquelle des zones de diélectrique (8) et des zones de silicium polycristallin (9) connectées aux lignes de grille de commande (15) sont superposées aux zones de grille flottante (6) et autoalignées avec celles-ci, les zones de diélectrique (8) et de silicium polycristallin (9) étant munies d'ailettes respectives (10, 11) superposées à des ailettes correspondantes (7) des zones de grille flottante sous-jacentes (6), caractérisée en ce que chacune des zones de grille flottante (6) est munie d'une unique ailette latérale (7) et en ce que les uniques ailettes latérales (7) des paires de zones de grille flottante adjacentes (6) qui sont interposées entre les mêmes lignes de source (2) et de drain (3) sont superposées à une surface de couplage importante au-dessus des extrémités exposées de zones correspondantes d'oxyde de champ (4) de sorte que sensiblement toutes les zones d'oxyde de champ (4) sont munies de paires correspondantes de zones de grille flottante (6).

2. Matrice de cellules (16) selon la revendication 1, caractérisée en ce que chaque ligne de source (2) alterne avec une paire de lignes de drain (3) et en ce que des bandes d'oxyde (17) sont interposées entre les lignes de drain (3).
